# DEMANDE DE BREVET EUROPEEN

(11) **EP 0 977 272 A1**
(43) Date de publication de la demande: **02.02.2000**
(21) Numéro de dépôt: 99410092.3
(22) Date de dépôt: 29.07.1999
(51) Int. Cl.: H01L 29/74

(54) **Générateur de courant constant**

(30) Priorité: 30.07.1998 FR 9809947
(71) Demandeur: STMicroelectronics SA, 94250 Gentilly (FR)
(72) Inventeur: Pezzani, Robert, 37210 Vouvray (FR)
(74) Mandataire: de Beaumont, Michel

(57) **Abrégé**

L'invention concerne un générateur de courant constant connecté entre des première (A) et deuxième (B) bornes, comprenant un thyristor (10) de type ouvrable par la gâchette (GTO) en série avec une résistance (11) ; un élément limiteur de courant (12) connecté entre la gâchette d'anode (GA) et la gâchette de cathode (GK) du thyristor ; et une référence de tension (Z) connectée entre la cathode et la gâchette de cathode du thyristor (10).

## Description

La présente invention concerne les générateurs ou limiteurs de courant et plus particulièrement des limiteurs de courant susceptibles d'être insérés dans des circuits de puissance auxquels peuvent être appliquées des tensions élevées, par exemple supérieures à la centaine de volts.

Un limiteur de courant est un composant disposé en série dans un circuit et destiné à limiter le courant dans le circuit à une valeur constante. Ainsi, un limiteur de courant est également souvent appelé générateur de courant.

Parmi les générateurs ou limiteurs de courant, l'un des plus connus est constitué d'un transistor MOS à déplétion dont la grille est connectée à la source. Un tel composant présente les inconvénients suivants :
- il incorpore une diode intrinsèque en anti-parallèle et ne présente donc pas de tenue en tension inverse ;
- il est difficile technologiquement d'ajuster les paramètres qui fixent le courant de limitation, en particulier la tension de seuil du transistor MOS et la valeur de la résistance du canal préformé ;
- la surface de silicium nécessaire à la réalisation du composant est relativement importante.

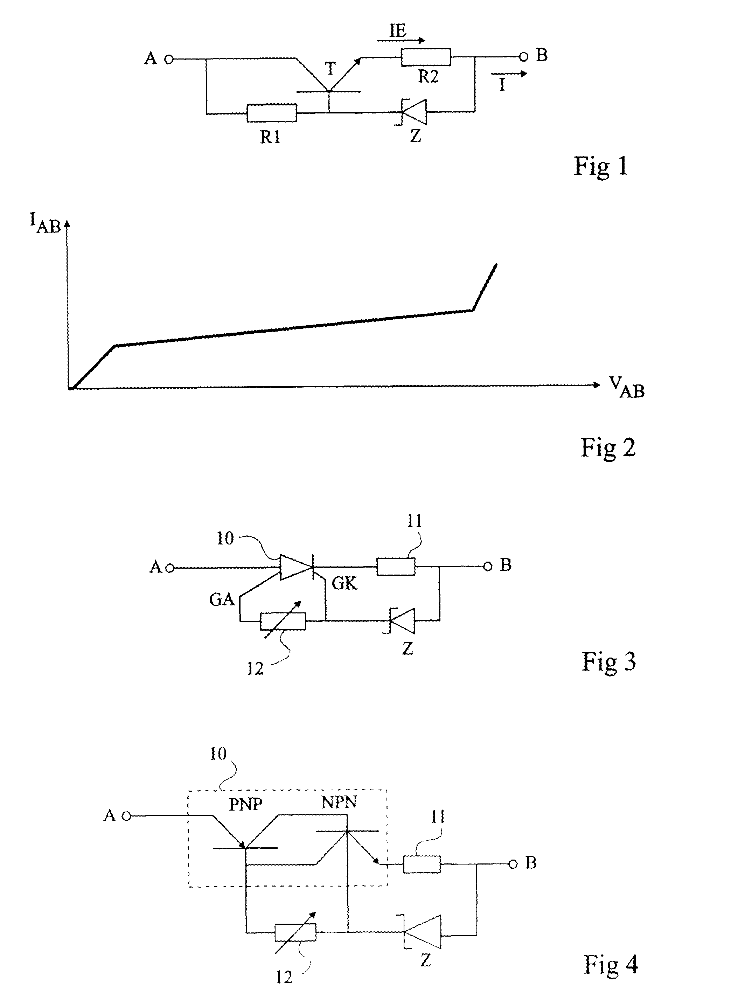

Un autre circuit simple permettant de réaliser un générateur de courant est représenté en figure 1. Ce circuit est connecté entre des bornes A et B, la borne A étant normalement positive par rapport à la borne B, et comprend la connexion en série d'un transistor T et d'une résistance R2. Une résistance R1 est connectée entre base et collecteur du transistor T. Une diode de référence ou diode à avalanche Z est connectée entre la base du transistor T et la borne B. Le courant d'émetteur Ie, qui circule dans la résistance R2 est égal à (Vz-Vbe)/R2. Les valeurs Vz et Vbe étant sensiblement constantes, ce courant Ie est sensiblement constant.

Ce circuit présente toutefois les inconvénients suivants :
1) il est limité à la présence de tensions faibles, c'est-à-dire qu'il faut que la tension entre les bornes A et B ne dépasse pas une valeur de seuil liée à la tenue en tension en direct du transistor T ; ce circuit fonctionne d'autant mieux que le transistor a un gain élevé ; ceci limite sa tenue en tension et augmente les risques de claquage ;
2) dans le cas où le composant est inséré dans un circuit où la polarité entre les bornes A et B est susceptible d'être inversée, il convient pour éviter de détruire le transistor par des courants inverses élevés de disposer une diode en série avec le transistor ; ceci rajoute au coût du composant et augmente sa consommation ;
3) si le courant Ie est effectivement sensiblement constant comme on l'a dit précédemment, par contre, le courant I sortant de la borne B est égal à la somme du courant Ie et du courant circulant dans la résistance R1 et la diode Z qui, en fonctionnement, est à l'état conducteur. Ce courant I dépend de la tension entre les bornes A et B et n'est donc pas constant. Le système a donc une caractéristique d'ensemble I_{AB}V_{AB} sensiblement telle que représentée en figure 2, c'est-à-dire que le courant de sortie varie d'une façon non négligeable avec la tension aux bornes.

Ce circuit est toutefois largement utilisé et préféré aux composants du type transistor MOS à déplétion à source et grille interconnectées car le courant de limitation peut être facilement fixé par des composants externes (Vz, R1...), alors que, dans le cas du transistor MOS, les paramètres d'ajustement sont internes (résistance de canal, tension de seuil...).

La présente invention vise à réaliser un générateur de courant constant qui pallie un ou plusieurs des inconvénients de chacun des limiteurs de courant connus.

Un autre objet de la présente invention est de prévoir un tel générateur de courant constant qui soit réalisable sous forme de composant monolithique, éventuellement associé à d'autres composants de puissance.

Pour atteindre ces objets ainsi que d'autres, la présente invention prévoit un générateur de courant constant connecté entre des première et deuxième bornes, comprenant un thyristor de type ouvrable par la gâchette en série avec une résistance ; un composant limiteur de courant connecté entre la gâchette d'anode et la gâchette de cathode du thyristor ; et une référence de tension connectée entre la cathode et la gâchette de cathode du thyristor.

Selon un mode de réalisation de la présente invention, la référence de tension est une diode à avalanche dont la cathode est connectée à la cathode du thyristor à ouverture par la gâchette.

Selon un mode de réalisation de la présente invention, l'élément limiteur de courant est une résistance.

Selon un mode de réalisation de la présente invention, l'élément limiteur de courant est une résistance saturable.

Selon un mode de réalisation de la présente invention, la résistance saturable comprend un caisson d'un premier type de conductivité comprenant des première et deuxième zones du deuxième type de conductivité reliées par une troisième zone du deuxième type de conductivité à faible niveau de dopage, la première zone du deuxième type de conductivité étant reliée à une région fortement dopée du premier type de conductivité reliée au substrat, le caisson étant porté à un premier potentiel et la deuxième zone du deuxième type de conductivité étant reliée à un deuxième potentiel.

La présente invention vise une réalisation d'un générateur de courant formé dans une zone d'un substrat semiconducteur d'un premier type de conductivité, comprenant une première région d'un deuxième type de conductivité formée du côté de la face arrière ; un premier caisson du deuxième type de conductivité formé du côté de la face supérieure ; une deuxième région du premier type de conductivité formée dans le premier caisson ; un deuxième caisson du deuxième type de conductivité formé du côté de la face supérieure ; une troisième région formée du côté de la surface supérieure dans le deuxième caisson ; une bande du deuxième type de conductivité formée du côté de la face supérieure du substrat. L'ensemble vertical de la première région, du substrat, du premier caisson et de la dernière région forme un thyristor à ouverture par la gâchette ; le deuxième caisson et la troisième région forment une diode à avalanche ; une portion du deuxième caisson forme une résistance ; et ladite bande forme une deuxième résistance.

Selon un mode de réalisation de la présente invention, ladite bande est une bande à faible niveau de dopage, d'où il résulte que la deuxième résistance est une résistance saturable à effet de pincement.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un limiteur de courant classique à transistor ;
la figure 2 représente la courbe courant/tension du limiteur de courant de la figure 1 ;
la figure 3 représente un limiteur de courant selon la présente invention ;
la figure 4 représente un schéma équivalent du limiteur de courant selon la présente invention ;
La figure 5 représente la caractéristique courant/tension d'un élément non linéaire utilisé dans le limiteur de courant selon la présente invention ;
la figure 6 représente un exemple de réalisation d'un élément non linéaire utilisé dans le limiteur de courant selon la présente invention ; et
la figure 7 représente un mode de réalisation sous forme monolithique du générateur de courant selon la présente invention.

la figure 3 représente le circuit d'un générateur de courant selon la présente invention. Celui-ci comprend entre des bornes A et B un thyristor 10 de type à ouverture par la gâchette (GTO) muni d'une gâchette d'anode et d'une gâchette de cathode. Ce thyristor GTO est connecté par son anode à la borne A et par sa cathode à la première borne d'une résistance 11 dont la deuxième borne est reliée à la borne B. Un élément de limitation de courant 12 est inséré entre la gâchette d'anode GA et la gâchette de cathode GK du thyristor 10. Une diode à avalanche Z est reliée par sa cathode à la gâchette de cathode GK du thyristor 10 et par son anode à la borne B.

Ainsi, quand le dispositif est en fonctionnement, le courant dans la résistance 11 ou courant de cathode du thyristor 10 est égal à (Vz-Vbe)/R, R étant la valeur de la résistance 11 et Vbe désignant la chute de tension entre la gâchette de cathode et la cathode du thyristor. Bien que l'on ait illustré que la fonction de tension de référence est assurée par une diode à avalanche Z, on notera que cette fonction pourrait être également réalisée par une série de diodes en direct ou encore par une alimentation externe connectée entre la gâchette de cathode GK et la sortie B.

La figure 4 représente le même schéma que celui de la figure 3 mais dans lequel le thyristor de type ouvrable par la gâchette 10 a été remplacé par son schéma équivalent à deux transistors. En effet, on peut considérer qu'un GTO 10 correspond à l'association de deux transistors PNP et NPN, l'émetteur du PNP correspondant à l'anode A du thyristor, la base du PNP étant connectée au collecteur du NPN et correspondant à la gâchette d'anode du thyristor, le collecteur du PNP étant connecté à la base du NPN et correspondant à la gâchette de cathode et l'émetteur du NPN correspondant à la cathode du thyristor.

On notera tout d'abord que la présente invention utilise un thyristor en mode de régulation. Ceci est tout à fait inhabituel. En effet, de façon générale, les thyristors et plus particulièrement les thyristors ouvrables par la gâchette (GTO) sont utilisés en mode de commutation, c'est-à-dire qu'ils sont commandés pour être ou bien dans un état bloqué ou bien dans un état totalement conducteur, l'état intermédiaire étant uniquement un état transitoire.

Si l'on considère les deux transistors NPN et PNP correspondant au thyristor GTO, à l'état bloqué, le produit des gains en courant (Hfe) des deux transistors est inférieur à 1. Quand une tension est appliquée entre les bornes A et B, un courant tend à circuler de la borne A, par l'intermédiaire de la jonction émetteur/base du transistor PNP, de la résistance 12, de la jonction base/émetteur du transistor NPN, et de la résistance 11, vers la borne B. L'amorçage se produit du fait que les gains des transistors PNP et NPN augmentent quand le courant augmente. Cette augmentation de courant correspond à un courant de gâchette. Dès que le produit des gains atteint 1, il y a amorçage. Le système se stabilise à un produit supérieur à 1. Il s'auto-entretient et le système reste conducteur même s'il n'y a plus de courant de gâchette. Par contre, le système tend à se rebloquer quand le produit des gains qui était supérieur à 1 tend à devenir inférieur à 1.

Ainsi, on provoque l'amorçage en utilisant simultanément la gâchette d'anode et la gâchette de cathode à travers la résistance 12, ce qui permet de solliciter en même temps les transistors PNP et NPN. Lorsque la tension aux bornes de la résistance 11 atteint la valeur Vz (plus sensiblement 0,7 volt correspondant à la tension base/émetteur du transistor NPN), la tension s'annule aux bornes de la base-émetteur et fait entrer le système en régulation. En effet, si la tension aux bornes de la résistance dépasse Vz + 0,7 V, un courant de gâchette négatif va sortir de la base du NPN. Le thyristor étant du type à ouverture par la gâchette, son courant d'anode, et donc le courant dans la résistance 11, va tendre à diminuer. La tension aux bornes de la résistance 11, de valeur R, redevient donc inférieure à Vz + 0,7 V et le courant de gâchette de cathode redevient positif. Le système trouve donc un point d'équilibre ou de régulation pour : R.I = Vz - 0,7 V

Ainsi, l'ensemble de la structure régule le courant jusqu'à une tension limitée par la tension que peuvent supporter ses divers éléments, à savoir le thyristor GTO 10, et les résistances 11 et 12. En fait, les résistances peuvent être des résistances haute tension et le thyristor GTO est lui-même naturellement un composant haute tension. Avec des composants relativement usuels, la régulation de courant peut être effective tandis que la tension aux bornes va jusqu'à des valeurs de plusieurs centaines de volts, par exemple 600 volts ou plus.

De plus, ces architectures supportent des tensions inverses de même amplitude que la tension directe maximum. En effet, la jonction de gâchette d'anode d'un thyristor peut supporter à l'inverse sensiblement la même tension que la tension inverse du composant, par exemple 600 volts. Ceci est dû, si l'on considère le schéma équivalent, à l'architecture du transistor PNP classique d'un thyristor. En effet, ce transistor PNP est symétrique et supporte donc la même tension en inverse et en direct.

On notera également qu'un thyristor GTO, adapté par exemple à laisser passer des courants de l'ordre de l'ampère, peut être conçu avec un gain très élevé à la fermeture (fermeture par des courants de gâchette de l'ordre du dixième de micro-ampère), et être rebloqué par des courants de gâchette faibles (quelques milliampères). On obtiendra donc une régulation particulièrement satisfaisante.

Le circuit selon la présente invention, illustré en figure 3, présente aussi par rapport au circuit classique de la figure 1 l'avantage de pouvoir supporter des tensions élevées tant en direct qu'en inverse, ce qui permet notamment d'éviter de l'associer à une diode série.

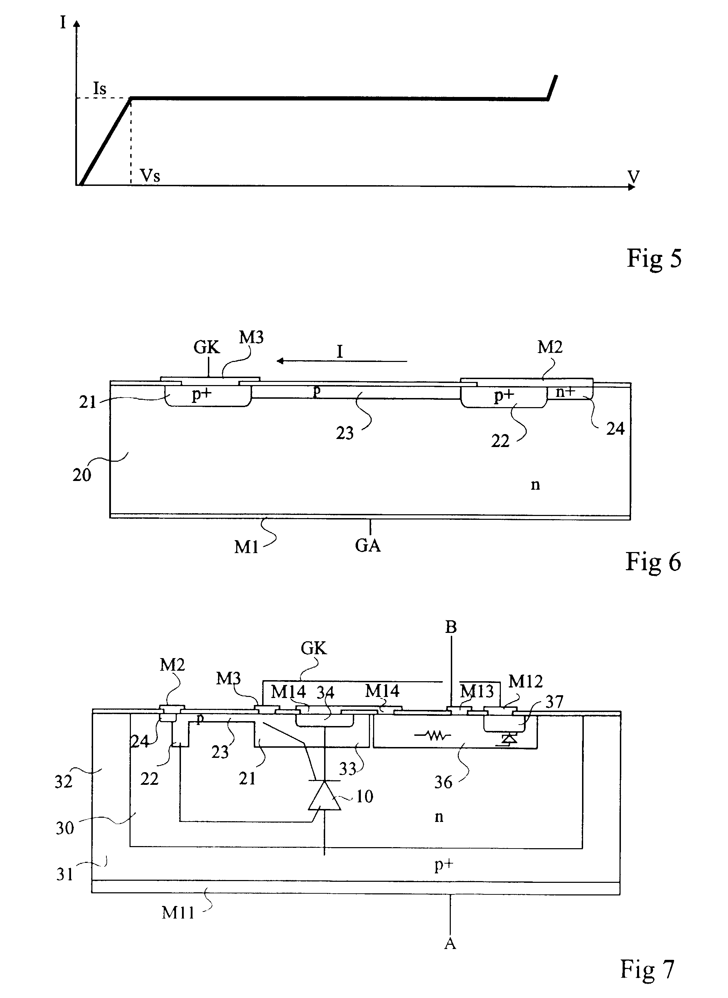

Selon un autre aspect de l'invention, on prévoit d'utiliser comme élément limiteur de courant 12 au lieu d'une simple résistance un élément de limitation de courant tel qu'une résistance saturable. Ce composant aura une caractéristique tension/ courant telle que celle représentée en figure 5 ayant par exemple une valeur de l'ordre de 75 Ω au zéro de tension et une valeur limitant son courant à une intensité de l'ordre du milliampère pour des tensions élevées allant par exemple jusqu'à 600 volts.

Une telle résistance variable peut par exemple être réalisée dans du silicium de la façon illustrée en figure 6. Dans un exemple de réalisation, le composant est formé dans un substrat 20 de type N dont la face arrière éventuellement surdopée est recouverte d'une métallisation M1 reliée à la borne GA. Du côté de la face supérieure, sont formées deux régions de type P fortement dopées 21 et 22 entre lesquelles est formée une région de type P faiblement dopée 23. De plus, il est formé une région 24 de type N fortement dopée adjacente à la région 22.

Les faces supérieures des régions 22 et 24 sont connectées par une métallisation M2 non connectée à une borne externe. La face supérieure de la région 21 est en contact avec une métallisation M3 reliée à la borne GK. Si une tension positive est appliquée sur la borne GA par rapport à la borne GK, on peut considérer que cette tension existe dans toute la région de substrat 20 et dans la région de type N fortement dopée 24, c'est-à-dire que la métallisation M2 est également au potentiel positif de la borne GA. Ainsi, un courant va circuler de la métallisation M2 vers la métallisation M3 dans la couche de type P faiblement dopée 23. Si la tension entre les bornes GA et GK augmente, ce courant I va croître jusqu'à ce que la vitesse limite des porteurs soit atteinte dans la couche 23. Alors le champ électrique à la jonction entre le substrat N et la région de type P faiblement dopée 23 va augmenter. La jonction PN étant une jonction en inverse va se dépléter et pincer le courant dans la région 23 ce qui compense l'accroissement de tension qui tend à se produire. La configuration de la région 23 et un choix approprié de son dopage permettent de régler le courant de pincement Is (voir figure 5). L'homme de l'art saura optimiser ces valeurs. A titre d'exemple, un dopage de la région 23 de 10¹² atomes/cm² redistribués sur une profondeur de 5 à 10 µm avec une longueur de la région 23 de l'ordre de 100 µm permet de tenir plus de 100 volts et de limiter le courant en dessous de 1 milliampère.

Bien entendu, la réalisation de la figure 6 ne constitue qu'un mode de réalisation possible d'un limiteur de courant utilisé à la place de la résistance 12 des figures 3 et 4. Ce mode de réalisation a été décrit en détail, car il peut être utilisé dans une réalisation monolithique du circuit de la figure 3.

La figure 7 représente une réalisation monolithique du composant de la figure 3 dans le cas où le limiteur de courant 12 est du type décrit précédemment en relation avec la figure 6.

La structure est formée dans un substrat 30 de type N dont la face inférieure porte une couche 31 de type P. De préférence, la structure est entourée d'un mur d'isolement 32 de type P. La partie 30 du substrat entourée du mur d'isolement 32 peut constituer une partie d'un composant plus important comprenant d'autres structures, par exemple d'autres composants de puissance et éventuellement des composants logiques. Le thyristor 20 est réalisé sous forme verticale. Son anode correspond à la région P 31, sa gâchette d'anode au substrat 30 de type N, sa gâchette de cathode à un caisson P 33 et sa cathode à une région 34 de type N formée dans le caisson P 33. Un autre caisson de type P 36 est formé du côté de la face supérieure du substrat 30 et contient une région de type N 37. La jonction entre les régions 36 et 37 correspond à la diode à avalanche Z de la figure 3. La structure illustrée en figure 6 est sensiblement reproduite dans la partie supérieure gauche de la figure 7. De mêmes régions y sont désignées par de mêmes références, la région 21 est en fait formée d'une partie du caisson 33.

La face arrière de cette structure est recouverte d'une métallisation M11 qui correspond à l'anode du thyristor. La métallisation M3, déjà décrite en relation avec la figure 6, est connectée à une métallisation M12 solidaire de la région 37 de cathode de la diode à avalanche Z. Deux métallisations M13 et M14, relativement éloignées l'une de l'autre, sont formées sur le caisson 36. La métallisation M13 correspond à la borne B qui est reliée à une première borne de la résistance 11 et la métallisation M14 correspond à la deuxième borne de la résistance 11 et se prolonge pour constituer la métallisation de cathode du thyristor.

On a ainsi réalisé sous forme monolithique tous les éléments constitutifs du schéma des figures 3 et 4.

Bien entendu, diverses variantes de réalisation pourront être imaginées par l'homme de l'art. Notamment, on connaît diverses façons de réaliser des résistances dans un circuit monolithique et diverses façons de réaliser des tensions de référence.

Par exemple, si l'on veut réaliser l'architecture selon la présente invention sous forme monolithique, on utilisera des valeurs "naturelles" dans la technologie considérée. La tension de référence sera par exemple choisie comme la tension inverse de la jonction gâchette/cathode. Cela conduit à des valeurs de l'ordre de 5 à 10 volts selon la filière de fabrication. La valeur R de la résistance 11 sera choisie en fonction du courant de limitation recherché d'après la formule R=(Vz-0,7)/I. On peut aisément réaliser des dispositifs pour lesquels le courant de limitation est situé dans une plage de 1 mA à 1 A.

## Revendications

1. Générateur de courant constant connecté entre des première (A) et deuxième (B) bornes, caractérisé en ce qu'il comprend :
un thyristor (10) de type ouvrable par la gâchette (GTO) en série avec une résistance (11) ;
un élément limiteur de courant (12) connecté entre la gâchette d'anode (GA) et la gâchette de cathode (GK) du thyristor ; et
une référence de tension (Z) connectée entre la cathode et la gâchette de cathode du thyristor (10).

2. Générateur de courant selon la revendication 1, caractérisé en ce que la référence de tension est une diode à avalanche (Z) dont la cathode est connectée à la cathode du thyristor à ouverture par la gâchette.

3. Générateur de courant selon la revendication 1, caractérisé en ce que l'élément limiteur de courant (12) est une résistance.

4. Générateur de courant selon la revendication 1, caractérisé en ce que l'élément limiteur de courant (12) est une résistance saturable.

5. Générateur de courant selon la revendication 4, caractérisé en ce que la résistance saturable comprend un caisson d'un premier type de conductivité (20) comprenant des première et deuxième zones du deuxième type de conductivité (21, 22) reliées par une troisième zone du deuxième type de conductivité (23) à faible niveau de dopage, la première zone du deuxième type de conductivité (22) étant reliée à une région fortement dopée du premier type de conductivité (24) reliée au substrat, le caisson étant porté à un premier potentiel et la deuxième zone du deuxième type de conductivité étant reliée à un deuxième potentiel.

6. Générateur de courant selon la revendication 1 formé dans une zone (30) d'un substrat semiconducteur d'un premier type de conductivité, caractérisé en ce qu'il comprend :
une première région (31) d'une deuxième type de conductivité formée du côté de la face arrière ;
un premier caisson (33) du deuxième type de conductivité formé du côté de la face supérieure ;
une deuxième région (34) du premier type de conductivité formée dans le premier caisson ;
un deuxième caisson (36) du deuxième type de conductivité formé du côté de la face supérieure ;
une troisième région (37) formée du côté de la surface supérieure dans le deuxième caisson ;
une bande (23) du deuxième type de conductivité formée du côté de la face supérieure du substrat ;
d'où il résulte que l'ensemble vertical de la première région, du substrat, du premier caisson et de la dernière région forme un thyristor à ouverture par la gâchette ;
que le deuxième caisson et la troisième région forment une diode à avalanche ;
qu'une portion du deuxième caisson forme une résistance ; et
que ladite bande forme une deuxième résistance.

7. Générateur de courant selon la revendication 6, caractérisé en ce que ladite bande est une bande à faible niveau de dopage, d'où il résulte que la deuxième résistance est une résistance saturable à effet de pincement.
